(19) Europäisches Patentamt
European Patent Office
Office européen des brevets

(11) **EP 3 745 146 B1**

(12) **EUROPÄISCHE PATENTSCHRIFT**

(45) Veröffentlichungstag und Bekanntmachung des Hinweises auf die Patenterteilung:
**25.10.2023 Patentblatt 2023/43**

(21) Anmeldenummer: **19177359.7**

(22) Anmeldetag: **29.05.2019**

(51) Internationale Patentklassifikation (IPC):
**G01R 31/08** (2020.01) **H02H 1/00** (2006.01)

(52) Gemeinsame Patentklassifikation (CPC):
**G01R 31/088;** G01R 31/3275; H02H 1/0015

(54) **VERFAHREN, VORRICHTUNG UND SYSTEM ZUR BESTIMMUNG EINER LEITUNGSEIGENSCHAFT EINER ENERGIEÜBERTRAGUNGSLEITUNG**

METHOD, DEVICE AND SYSTEM FOR DETERMINING A CHARACTERISTIC OF A POWER TRANSMISSION LINE

PROCÉDÉ, DISPOSITIF ET SYSTÈME DE DÉTERMINATION D'UNE PROPRIÉTÉ D'UNE LIGNE DE TRANSMISSION D'ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**02.12.2020 Patentblatt 2020/49**

(73) Patentinhaber: **Siemens Aktiengesellschaft 80333 München (DE)**

(72) Erfinder:
• **Frankenberg, Robert 1210 Wien (AT)**
• **Ira, Gottfried 1080 Wien (AT)**

(74) Vertreter: **Siemens Patent Attorneys Postfach 22 16 34 80506 München (DE)**

(56) Entgegenhaltungen:
CN-A- 108 008 244    US-A1- 2013 226 479
US-A1- 2018 115 144

• **KEENAN J ET AL: "ARC DETECTORS", 20TH INTERNATIONAL TELECOMMUNICATIONS ENERGY CONFERENCE. INTELEC '98. SAN FRANCISCO, CA, OCT. 4 - 8, 1998; [INTELEC. INTERNATIONAL TELECOMMUNICATIONS ENERGY CONFERENCE], NEW YORK, NY : IEEE, US, 4. Oktober 1998 (1998-10-04), Seiten 710-715, XP000896377, ISBN: 978-0-7803-5070-0**

**Beschreibung**

Die Erfindung betrifft ein Verfahren zur Bestimmung eines Lichtbogens auf einer Energieübertragungsleitung, wobei zumindest ein Prüfsignal in die Energieübertragungsleitung eingekoppelt wird, und ein Störsignal an einer Störstelle, welche durch den Lichtbogen gebildet ist, längs der Energieübertragungsleitung mithilfe des zumindest einen Prüfsignals erzeugt wird, welches Störsignal als zumindest ein Messsignal erfasst wird, und aus dem zumindest einen Messsignal der Lichtbogen bestimmt wird. Die Erfindung betrifft außerdem eine Vorrichtung und ein System zur Bestimmung eines Lichtbogens auf einer Energieübertragungsleitung, umfassend zumindest ein Koppelmittel zum Einkoppeln zumindest eines Prüfsignals und zum Auskoppeln zumindest eines Messsignals in und aus der Energieübertragungsleitung, und eine Verarbeitungs-Vorrichtung mit einer Steuer-Vorrichtung, zumindest einer Generator-Vorrichtung und zumindest einer Messvorrichtung, wobei die Steuer-Vorrichtung dazu eingerichtet ist, mithilfe der zumindest einen Generator-Vorrichtung das zumindest eine Prüfsignal zu erzeugen, und mithilfe des zumindest einen Koppelmittels in die Energieübertragungsleitung einzuspeisen, und zumindest ein Störsignal, welches an zumindest einer Störstelle, welche durch den Lichtbogen gebildet ist, längs der Energieübertragungsleitung mithilfe des zumindest einen Prüfsignals erzeugt wird, mithilfe des zumindest einen Koppelmittels von der Energieübertragungsleitung auszukoppeln, und mithilfe der zumindest einen Messvorrichtung als das zumindest eine Messsignal zu erfassen.

Bei Übertragungsnetzen besteht der Wunsch, Störungen möglichst rasch zu erkennen, um eine hohe Verfügbarkeit beziehungsweise eine hohe Sicherheit des Netzes zu gewährleisten. Die im Stand der Technik bekannten Verfahren weisen jedoch häufig unzureichende Zuverlässigkeit bei der Erkennung von Störungen auf.

Beispielsweise können durch "Synchro-Phasor"-Messungen mithilfe verteilter Sensoren Momentan-Werte für Strom und Spannung erfasst werden. Daraus kann in weiterer Folge versucht werden, auf eine mögliche Störung rückzuschließen. Jedoch ist eine entsprechende Realisierung aufwändig und teuer, da die Sensoren untereinander aufwändig synchronisiert beziehungsweise aufwändige Messungen durchgeführt werden müssen. Andere Verfahren versuchen über eine Analyse des Frequenzspektrums von Oberwellen der Frequenz der Netzspannung eine entsprechende Aussage zur Erkennung von Störungen zu treffen, was jedoch nicht immer zu zufriedenstellenden Ergebnissen führt.

Die zuverlässige Erkennung von Störungen, welche durch einen Überschlag oder Entladungen in Form eines intermittierenden Lichtbogens in einem Energieversorgungsnetz hervorgerufen werden können, ist von hoher Relevanz. Die Erkennung von kleinen Fehlerströmen ist besonders wichtig, das heißt von "High-Impedance Faults" mit weniger als zehn Ampere. Solche Störungen, insbesondere Lichtbögen, können als eine Leitungseigenschaft einer Energieübertragungsleitung beschrieben werden.

In der elektrischen Energietechnik bei Schalthandlungen auftretende Lichtbögen werden als Schaltlichtbogen bezeichnet. Unerwünschte Lichtbögen, die oft Schäden oder Unfälle zur Folge haben, werden als Störlichtbogen bezeichnet.

Ein Lichtbogen entsteht bei ausreichend hoher elektrischer Potentialdifferenz und Stromdichte durch Stoßionisation. Die Gasentladung bildet ein Plasma, in dem die Teilchen wie Atome oder Moleküle zumindest teilweise ionisiert sind. Die freien Ladungsträger haben zur Folge, dass das Gas elektrisch leitfähig wird. Die meisten Plasmen sind quasi neutral, die Zahl der Ionen und Elektronen ist also identisch. Da die Ionen gegenüber den viel leichteren Elektronen wesentlich langsamer sind, sind für den Stromtransport oft fast ausschließlich die Elektronen relevant.

Die zuverlässige Erkennung von einmaligen oder intermittierenden Lichtbögen, insbesondere solche mit geringen Strömen ("High-Impedance Fault" mit weniger als zehn Ampere), ist in einem Energieversorgungsnetz über große Entfernungen häufig schwierig.

Ein direkt durch einen Lichtbogen erzeugtes Störsignal kann im Frequenzbereich sehr breitbandig sein. Die hohe Dispersion von Netzleitungen kann das breitbandige Störsignal derart ungünstig beeinträchtigen, dass es nach einer entsprechenden Entfernung längs einer Netzleitung für eine zuverlässige Erkennung nicht mehr aussagekräftig ist.

In der Veröffentlichung US 2018/115144 A1 ist ein System zur Erkennung eines Lichtbogens auf einem Gleichspannungs-System wie ein Solarpanel beschrieben, welches auf einer Frequenz-Spektralanalyse beruht.

In der Publikation US 2013/226479 A1 ist ein System zur Erkennung von Lichtbögen genannt, welches eine Analyse der Signalform des Lichtbogens durchführt.

Die Schrift CN 108 008 244 A betrifft ein mehrstufiges progressives Klassifizierungs- und Identifikationsverfahren für Erdschlüsse mit kleinem Strom.

In der Veröffentlichung von KEENAN J ET AL: "ARC DETECTORS", 20TH INTERNATIONAL TELECOMMUNICATIONS ENERGY CONFERENCE, INTELEC '98, SAN FRANCISCO, CA, OCT. 4 - 8, 1998; [INTELEC. INTERNATIONAL TELECOMMUNICATIONS ENERGY CONFERENCE], NEW YORK, NY: IEEE, US, 4. Oktober 1998 (1998-10-04), Seiten 710-715, XP000896377, ISBN: 978-0-7803-5070-0 wird eine Schutzschaltung für Telefonleitungen zum Schutz vor den Auswirkungen eines Lichtbogens beschrieben.

Es ist Aufgabe der Erfindung ein Verfahren bereitzustellen, welches die Nachteile im Stand der Technik überwindet und dass Störungen in Mittel- oder Hochspannungsnetzen zuverlässig und kostengünstig erkannt werden können.

Die Aufgabe wird durch ein Verfahren eingangs genannter Art gelöst, wobei der Lichtbogen durch Detektion zumindest eines Intermodulations-Produkts aus dem zumindest einen Prüfsignal und dem Netzsignal der Energieübertragungsleitung in dem zumindest einen Messsignal bestimmt wird.

Dadurch wird auf einfache Weise erreicht, dass eine Störstelle, welche Intermodulationsprodukte aus einem Prüfsignal und einem Netzsignal der Energieübertragungsleitung erzeugt, zuverlässig erkannt werden kann.

Beispielsweise kann es beim Öffnen oder Schließen von Hoch- oder Mittelspannungsschaltern zu einem Überschlag in Form eines Lichtbogens oder einem andauernden, stehenden Lichtbogen zwischen den Kontakten eines Schalters kommen. Ein solcher Lichtbogen kann dazu führen, dass ein elektrisches Signal, welches in die Hochspannungsleitung eingespeist wird, am Ort des Lichtbogens ein Störsignal erzeugt. Ein derartiger Schalter kann beispielsweise ein mit der Energieübertragungsleitung in Serie geschalteter Trenner sein.

Für einen derartigen Lichtbogen ist ein elektrisch nichtlineares Verhalten charakteristisch, welches mithilfe eines negativen differentiellen Widerstands beschrieben werden kann.

Wird ein Prüfsignal an eine Störstelle mit negativem differentiellem Widerstand angelegt, so werden Intermodulationsprodukte des Prüfsignals und des Nutzsignals, das heißt der Netzspannung mit der Netzfrequenz erzeugt, welche messbar und auswertbar sind.

Die Intermodulation bezeichnet die Entstehung von Frequenzen, wenn zwei oder mehr unterschiedliche Frequenzen durch ein System mit nichtlinearer Übertragungsfunktion verarbeitet werden.

Im einfachsten Fall von zwei unterschiedlichen Frequenzen $f_1$ und $f_2$, welche durch ein System mit nichtlinearen Übertragungsfunktion geleitet werden, bildet sich durch Intermodulation eine Summe von Frequenzen, die als Intermodulationsprodukte bezeichnet werden, in der Form:

$$k_1 f_1 \pm k_2 f_2$$

beziehungsweise

$$k_1 f_1 \pm k_2 f_2 \pm k_3 f_3$$

für einen Fall mit drei Frequenzen, mit $k_1, k_2, k_3 \in \mathbb{Z}$. Die Ordnung $O$ ist

$$O = |k_1| + |k_2|$$

beziehungsweise

$$O = |k_1| + |k_2| + |k_3|$$

Einige Intermodulationsprodukte im Fall bei zwei Frequenzen $f_1$ und $f_2$ sowie bei drei Frequenzen $f_1$, $f_2$ und $f_3$ sind beispielhaft in Tabelle 1 angeführt:

Tabelle 1: Ordnung von Intermodulationssignalen

| Ordnung | Intermodulationsprodukte bei zwei Frequenzen | Intermodulationsprodukte bei drei Frequenzen |
|---|---|---|
| 2. Ordnung | $f_1 \pm f_2$ | |
| 3. Ordnung | $2f_1 \pm f_2$ <br> $f_1 \pm 2f_2$ | $f_1 \pm f_2 \pm f_3$ |
| 4. Ordnung | $3f_1 \pm f_2$ <br> $f_1 \pm 3f_2$ <br> $2f_1 \pm 2f_2$ | $2f_1 \pm f_2 \pm f_3$ <br> $f_1 \pm 2f_2 \pm f_3$ |

EP 3 745 146 B1

(fortgesetzt)

| Ordnung | Intermodulationsprodukte bei zwei Frequenzen | Intermodulationsprodukte bei drei Frequenzen |
|---|---|---|
| 5. Ordnung | $3f_1 \pm 2f_2$ <br><br> $2f_1 \pm 3f_2$ <br> $4f_1 \pm f_2$ <br><br> $f_1 \pm 4f_2$ | $2f_1 \pm 2f_2 \pm f_3$ <br> $f_1 \pm 2f_2 \pm 2f_3$ <br> $2f_1 \pm f_2 \pm 2f_3$ <br> $3f_1 \pm f_2 \pm f_3$ <br> $f_1 \pm 3f_2 \pm f_3$ <br> $f_1 \pm f_2 \pm 3f_3$ |

Die Frequenz $f_1$ kann beispielweise die Netzfrequenz eines Netzsignals (z.B. 50 oder z.B. 60 Hz) sein, und die Frequenzen $f_2$ beziehungsweise $f_3$ können von einem Prüfsignal umfasst sein.

Es können Intermodulationsprodukte auch mit mehr als drei Frequenzen in einem Prüfsignal erzeugt werden.

Das erfindungsgemäße Verfahren weist außerdem den Vorteil auf, dass von einem zentralen Punkt aus, wie beispielsweise ein Umspannwerk, Überschläge im Netz auch in großer Entfernung zuverlässig erkannt werden können.

Grundsätzlich kann das Verfahren für jeden Leitungstyp, der zur Energieübertragung geeignet ist, verwendet werden. Solche Leitungstypen sind beispielsweise Freileitungen, Kabel, Gasisolierte Rohrleiter (GIL) oder Oberleitungen bei der Bahn in verschiedenen Konfigurationen wie Mehrphasenleitungen, Einphasenleitungen oder Gleichstromleitungen.

Meist werden im Hoch- und Mittelspannungsbereich Mehrphasenleitungen zur Energieübertragung verwendet.

Als Leitungseigenschaft kann ein Indikator für die Detektion eines Kabelbruchs oder eines hochohmigen Erdschlusses ohne Leitungsunterbrechung, wie er beispielsweise durch eine durchhängende Freileitung oder eine Berührung der Leitung durch einen Baum hervorgerufen werden kann, gebildet werden. Der Lichtbogen kann auch auf den Ort einer detektierten Störung hinweisen.

Die Störstelle ist durch einen Lichtbogen gebildet.

Mit anderen Worten kann an der Störstelle ein in eine Energieübertragungsleitung eingespeistes Prüfsignal durch die nichtlineare Eigenschaft des Lichtbogens ein Störsignal erzeugt werden, welches Intermodulationsprodukte aufweist und als Messsignal von einer Verarbeitungs-Vorrichtung erfasst und ausgewertet werden kann.

Es können auch mehrere Prüfsignale in dasselbe Energieübertragungsleitung eingespeist werden, beispielsweise an verschiedenen Orten, um die Reichweite der Prüfvorrichtung zu erhöhen.

Ferner kann ein gemeinsames Prüfsignal mit mehreren Prüffrequenzen verwendet werden, um gezielt Intermodulationsprodukte zu erzeugen, welche durch ihre Frequenzlage besonders vorteilhafte Eigenschaften, beispielsweise bei der Ausbreitung im Energieübertragungsnetz, aufweisen und dadurch die Erkennungsrate beziehungsweise deren Zuverlässigkeit weiter verbessern.

In einer Weiterbildung der Erfindung ist es vorgesehen, dass der Lichtbogen durch einen Schaltvorgang eines, mit der Energieübertragungsleitung verbundenen Hochspannungsschalters hervorgerufen wird.

Dadurch wird erreicht, dass der Lichtbogen gezielt erzeugt werden kann, und so eine Bestimmung der Leitungseigenschaft systematisch erfolgen kann.

Hochspannungsschalter können Leistungsschalter, Lastschalter, Lasttrennschalter oder Trenner sein. Hochspannungsschalter werden in Umspannwerken, Lastverteilerwerken oder auch im Bereich von Kraftwerken eingesetzt und aus Leitzentralen ferngesteuert. Sie können mit Motor-, Federspeicher- oder Druckluftantrieb ausgestattet sein. Kompakte Bauformen finden sich in gasisolierten Schaltanlagen.

Bei einer Verwendung im Bahn- oder Transportbereich kann als Hochspannungsschalter auch ein Stromabnehmer eines Fahrzeugs, wie einer Elektro-Lokomotive oder eines Oberleitungsbusses zur Verbindung mit einem streckenseitig montierten Fahrdraht Strecke verstanden werden.

In einer Weiterbildung der Erfindung ist es vorgesehen, dass der Zeitpunkt des Schaltvorganges bei der Bestimmung des zumindest einen Leitungsparameters berücksichtigt wird.

Da in diesem Fall Ort und Zeitpunkt des Lichtbogens bekannt sind, kann ein erfasstes Messsignal eindeutig dem auslösenden Schaltvorgang zugeordnet werden.

In einer Weiterbildung der Erfindung ist es vorgesehen, dass der Lichtbogen durch eine Detektion ungeradzahliger Intermodulationsprodukte im Messsignal bestimmt wird.

Dadurch wird eine besonders zuverlässige Detektion eines Lichtbogens erreicht. Es kann dadurch auf einfache Weise von anderen Störeinflüssen unterschieden werden, welche auch geradzahlige Intermodulationsprodukte im Messsignal erzeugen.

In einer Weiterbildung der Erfindung ist es vorgesehen, dass der Lichtbogen durch zumindest ein Intermodulationsprodukt bestimmt wird, welches maximal die zehnte Ordnung aufweist.

Dadurch wird eine besonders zuverlässige Detektion eines Lichtbogens erreicht.

In einer Weiterbildung der Erfindung ist es vorgesehen, dass der zumindest eine Lichtbogen durch zumindest zwei Intermodulationsprodukte bestimmt wird.

Dadurch wird erreicht, dass die Zuverlässigkeit bei der Bestimmung des Leitungsparameters weiter verbessert werden kann.

In einer Weiterbildung der Erfindung ist es vorgesehen, dass der Lichtbogen durch das Verhältnis von Amplituden- und/oder Phasenbeträgen der zumindest zwei Intermodulationsprodukte bestimmt wird.

Dadurch wird erreicht, dass die Zuverlässigkeit bei der Bestimmung des Leitungsparameters weiter verbessert werden kann, da der Signal-zu-Störabstand erhöht werden kann.

In einer Weiterbildung der Erfindung ist es vorgesehen, dass der zumindest eine Lichtbogen zusätzlich durch zumindest eine Harmonische des zumindest einen Prüfsignals und/oder des zumindest einen Intermodulationsprodukts bestimmt wird.

Dadurch kann die Zuverlässigkeit bei der Bestimmung des Leitungsparameters weiter verbessert werden.

In einer Weiterbildung der Erfindung ist es vorgesehen, dass das zumindest ein Prüfsignal schmalbandig ist, das heißt ein Verhältnis zwischen der Bandbreite und der Mittenfrequenz des Prüfsignals von weniger als 10%, bevorzugt weniger als 5%, besonders bevorzugt weniger als 3% oder weniger als 1,5% aufweist.

Dadurch wird erreicht, dass das Messsignal durch Dispersion auf der Energieübertragungsleitung nicht wesentlich beeinträchtigt wird.

In einer Weiterbildung der Erfindung ist es vorgesehen, dass das zumindest eine Referenzsignal eine Frequenz aufweist, welche um einen Faktor 20 größer ist, als die Netzfrequenz der Energieübertragungsleitung, bevorzugt um einen Faktor 50 größer ist, besonders bevorzugt um einen Faktor 500 oder 1000 größer ist.

Dadurch wird erreicht, dass das Messsignal im Frequenzbereich abseits von Frequenzen gelegen ist, welche durch allgemeine Störungen auf der Energieübertragungsleitung hervorgerufen werden.

Die Leitungsdispersion einer Energieübertragungsleitung, wie einer Mehrphasen-Netzleitung, kann bei Signalen von weniger als 1 kHz Bandbreite als im Wesentlichen konstant angesehen werden.

Dadurch können die relativen Amplituden einzelner Mischprodukte zueinander näherungsweise als von der Netzleitung, zwischen dem Überschlag und der Messeinrichtung, unabhängig angesehen werden.

In einer Weiterbildung der Erfindung ist es vorgesehen, dass zumindest eine Phasenbeziehung zwischen dem zumindest einen Prüfsignal und dem zumindest einen Messsignal bestimmt wird, welche zur Bestimmung des Orts des Auftretens der Störstelle der Energieübertragungsleitung verwendet wird.

Dadurch wird eine Lokalisierung der Störstelle der Energieübertragungsleitung erleichtert.

Die Aufgabe der Erfindung wird auch durch eine Vorrichtung eingangs genannter Art gelöst, wobei die Verarbeitungs-Vorrichtung dazu eingerichtet ist, das erfindungsgemäße Verfahren auszuführen und aus dem zumindest einen Messsignal der zumindest eine Lichtbogen zu bestimmen.

In einer Weiterbildung der Erfindung ist es vorgesehen, dass die Energieübertragungsleitung eine Freileitung, ein Kabel oder ein gasisolierter Rohrleiter eines Energieübertragungsnetzes sein.

Die Aufgabe der Erfindung wird auch durch ein System zur Bestimmung eines Lichtbogens einer Energieübertragungsleitung in Form einer Oberleitung, umfassend ein elektrisch betriebenes Verkehrsmittel mit einem Stromabnehmer zur Verbindung mit der Oberleitung und eine erfindungsgemäße Vorrichtung, wobei die Störstelle durch einen Lichtbogen zwischen der Oberleitung und dem Stromabnehmer gebildet ist.

Die Oberleitung ist dafür vorgesehen, für ein elektrisch betriebenes Verkehrsmittel, welches die Energie zum Betrieb des Verkehrsmittels aus der Energieübertragungsleitung, beispielsweise über einen Stromabnehmer bezieht.

Das elektrisch betriebene Fahrzeug beziehungsweise Verkehrsmittel kann beispielsweise ein Zug, eine Straßenbahn, ein Bus oder ein Lastkraftwagen sein.

Dadurch wird erreicht, dass eine elektrische Ankopplung eines beweglichen, elektrisch betriebenen Fahrzeugs an eine Oberleitung einmalig oder auch kontinuierlich während der Fahrt geprüft werden kann. Dadurch kann beispielsweise die Abnützung des Stromabnehmers oder der Oberleitung geprüft werden, indem die Anzahl oder Intensität von Lichtbögen ausgewertet wird. Die Erfindung wird nachfolgend anhand in den beigeschlossenen Zeichnungen dargestellten Ausführungsbeispielen näher erläutert. In den Zeichnungen zeigt:

Fig. 1    ein erstes Ausführungsbeispiel für ein Blockschaltbild einer erfindungsgemäßen Schaltungsanordnung mit einer Ankopplung eines Referenzsignals an alle Phasen der Energieübertragungsleitung,

Fig. 2    ein zweites Ausführungsbeispiel für ein Blockschaltbild einer erfindungsgemäßen Schaltungsanordnung mit einer Ankopplung eines dreiphasigen Referenzsignals an den virtuellen Sternpunkt der Energieübertragungsleitung,

Fig. 3    ein erstes Beispiel für ein Messsignal, welches Intermodulationsprodukte aufweist,

Fig. 4    ein zweites Beispiel für ein Messsignal, welches Intermodulationsprodukte aufweist,

Fig. 5    ein drittes Beispiel für ein Messsignal, welches keine Intermodulationsprodukte aufweist,

Fig. 6    ein viertes Beispiel für ein Messsignal, welches Intermodulationsprodukte aufweist.

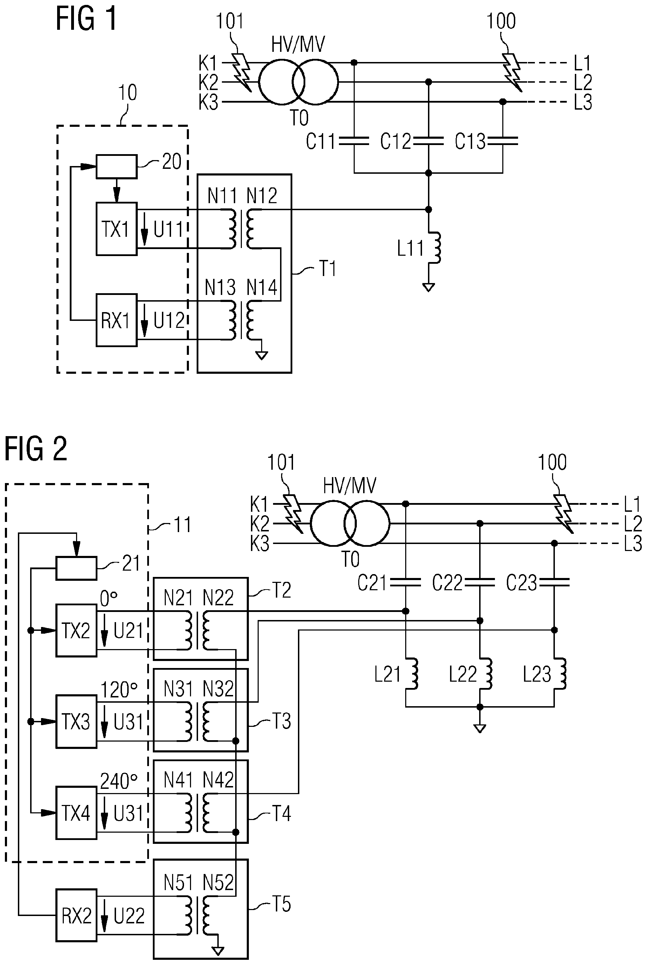

**Fig. 1** zeigt ein erstes Ausführungsbeispiel für eine erfindungsgemäße Vorrichtung mit einer Ankopplung eines Referenzsignals an alle Phasen einer dreiphasigen Energieübertragungsleitung.

Die Erfindung kann durch eine elektronische Schaltung gebildet sein, welche eine Vorrichtung zur Bestimmung zumindest eines Lichtbogens einer Energieübertragungsleitung K1-K3, L1-L3 in Form einer Mehrphasenleitung darstellt.

Die Energieübertragungsleitung K1-K3 stellt eine Hochspannungsleitung dar und die Energieübertragungsleitung L1-L3 eine Mittelspannungsleitung, wobei die einzelnen Leitungen der beiden Energieübertragungsleitungen K1-K3, L1-L3 über einen entsprechenden Transformator T0 miteinander gekoppelt sind.

Eine Verarbeitungs-Vorrichtung 10 verfügt über eine Steuer-Vorrichtung 20, eine Generator-Vorrichtung TX1 und eine Messvorrichtung RX1.

Die Steuer-Vorrichtung 20 ist dazu eingerichtet, mithilfe der Generator-Vorrichtung TX1 ein Prüfsignal U11 zu erzeugen und mithilfe des Koppelmittels in die Energieübertragungsleitung L1-L3 einzuspeisen.

Die Vorrichtung der Fig. 1 weist ein Koppelmittel zum Einkoppeln eines Signals U11 in die Energieübertragungsleitung L1-L3 und zum Auskoppeln eines Signals U12 aus der Energieübertragungsleitung L1-L3 auf.

Das Koppelmittel ist in diesem Beispiel durch eine entsprechende Koppelschaltung mit einem Transformator T1 mit Wicklungen N11, N12, N13 und N14, Kondensatoren C11-C13 und einer Induktivität L11 gebildet.

Die Wicklungen N11, N12, N13 und N14 des Transformators T1 sind über einen gemeinsamen Eisen- oder Ferritkern miteinander stark angekoppelt.

Die Koppelschaltung erlaubt eine Einspeisung des Prüfsignals U11 und eine Auskopplung des Messsignals U12 mittels des Transformators T1 und der Kondensatoren C11-C13 in die/aus den einzelnen Leitungen der Energieübertragungsleitung L1-L3.

Der Transformator T1 sorgt für eine galvanische Entkopplung der Generator-Vorrichtung TX1 bzw. der Messvorrichtung RX1 gegenüber der Mittelspannung auf der Energieversorgungsleitung L1-L3.

Die Steuer-Vorrichtung 20 ist ferner dazu eingerichtet, ein Störsignal, welches an einer Störstelle 100 längs der Energieübertragungsleitung L1-L3 erzeugt wird, mithilfe des Koppelmittels von der Energieübertragungsleitung L1-L3 auszukoppeln und mithilfe der Messvorrichtung RX1 als Messsignal U12 zu erfassen.

Die Störstelle 100, 101 kann eine Störstelle sein, welche durch einen Lichtbogen am Ort des Lichtbogens gebildet ist.

Die Störstelle 100 führt dazu, dass das in die Leitung K1-K3, L1-L3 eingespeiste Prüfsignal U11 ein Störsignal mit Intermodulationsprodukten erzeugt, welche als Messsignal U12 von der Verarbeitungs-Vorrichtung 10 erfasst werden kann.

Die Verarbeitungs-Vorrichtung 10 ist ferner dazu eingerichtet, das erfindungsgemäße Verfahren auszuführen und aus dem Messsignal U12 den Lichtbogen zu bestimmen.

Dabei wird das Prüfsignal U11 in die Energieübertragungsleitung L1-L3 eingekoppelt. An der Störstelle 100 längs der Energieübertragungsleitung L1-L3, welche durch einen Lichtbogen hervorgerufen ist, wird ein Störsignal mit Intermodulationsprodukten erzeugt und als das Messsignal U12 wieder empfangen.

Die Störstelle 100 kann längs der Energieübertragungsleitung des Mittelspannungsnetzes L1-L3 durch einen Lichtbogen auftreten, aber auch längs der Energieübertragungsleitung des Hochspannungsnetzes K1-K3 als Störstelle 101, wobei der Transformator T0 Signale bei Messfrequenzen im Messsignal U12, also Intermodulationsprodukte, von einer Seite K1-K3 auf die andere Seite L1-L3 des Transformators T0 überkoppelt. Es kann dabei notwendig sein, entsprechende Maßnahmen vorzusehen, welche eine erwünschte Überkopplung bei den relevanten Frequenzen verbessern.

Aus dem Messsignal U12 wird der Lichtbogen bestimmt, wobei der Lichtbogen ein Indikator für das Auftreten der Störstelle 100 ist.

Die Leitungseigenschaft wird durch eine Detektion eines Intermodulationsprodukts aus dem Prüfsignal U11 und dem Netzsignal der Energieübertragungsleitung K1-K3, L1-L3 in dem Messsignal U12 bestimmt.

Das Intermodulationsprodukt im Messsignal U12 an einem Lichtbogen an der Störstelle 100 der Energieübertragungsleitung L1-L3 erzeugt.

Der Lichtbogen kann gesteuert durch einen Schaltvorgang eines Hochspannungsschalters, wie einem Scherentrenner, entlang der Energieübertragungsleitung verursacht werden, wodurch der Zeitpunkt des Schaltvorgangs erfasst werden kann oder vorab bestimmt sein kann.

Der Zeitpunkt des Schaltvorgangs kann bei der Bestimmung des Leitungsparameters berücksichtigt werden, um die Auswertung des Messsignals U12 zu vereinfachen.

Der Lichtbogen kann auch durch zwei oder mehrere Intermodulationsprodukte bestimmt werden.

Der Lichtbogen kann zusätzlich durch eine Harmonische des Prüfsignals U11 bestimmt werden.

Das Prüfsignal U11 ist sinusförmig und schmalbandig, das heißt weist in diesem Beispiel ein Verhältnis zwischen der Bandbreite und der Mittenfrequenz von unter 1% auf.

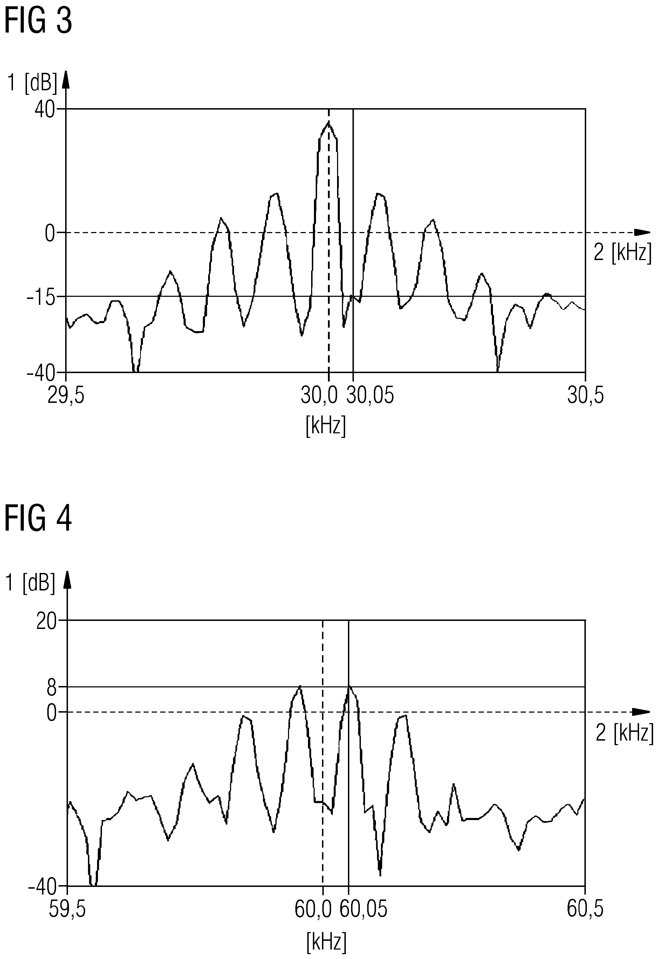

Das Prüfsignal U11 liegt bei einer Frequenz von 30 kHz und liegt gemäß Fig. 3 bei einer Frequenz, welche um einen Faktor 600 größer ist, als die Netzfrequenz von z.B. 50 oder z.B. 60 Hz der Energieübertragungsleitung K1-K3, L1-L3.

Schalthandlungen in elektrischen Energieversorgungsnetzen werden im Allgemeinen durch Lichtbögen begleitet. Diese können fälschlicherweise als Fehler erkannt werden.

Da die Schalthandlungen jedoch a priori bekannt sind, kann eine entsprechende Fehlermeldung unterdrückt werden.

Ferner kann eine Schalthandlung auch dazu genützt werden, die Funktion des Koppelmittels und der Messvorrichtung zu prüfen, indem ein Prüfsignal zeitgleich mit der Schalthandlung eingespeist wird und entsprechend ausgewertet wird.

Als Prüfsignal kann auch ein Kommunikationssignal eines PLC-Systems (Powerline Communication) verwendet werden.

Eine Einspeisung des Referenzsignals kann in jede Phase des Mehrphasennetzes vorgenommen werden. Analog dazu kann die Auskopplung des Messsignals erfolgen.

Die Reichweite des Verfahrens, das heißt die Distanz zwischen einer Messvorrichtung und einem Fehlerort kann durch regulatorische Bestimmungen, wie etwa eine maximal zulässige Sendeleistung für PLC-artige Einrichtungen, beschränkt sein.

Bei großen Netzen kann es daher notwendig sein, zwei oder mehrere Messeinrichtungen vorzusehen. Dabei können Messeinrichtungen zur Reduktion oder Verhinderung von gegenseitigen Störungen auf verschiedenen Frequenzen arbeiten.

Bei Kenntnis der genauen Phasen von Messsignalen an verschiedenen Orten, beispielsweise mithilfe mehrerer Messeinrichtungen, kann nach einer Synchronisierung der Messsignale mithilfe von Referenzsignalen oder Verwendung von GPS-Zeit-Referenzen eine Eingrenzung des Fehlerortes erfolgen.

Eine Auswertung der Phasendrehung eines Messsignals unter Berücksichtigung von getätigten Schalthandlungen im Netz können eine Funktionsüberprüfung oder eine automatische Neukalibration der Distanzbestimmung erlauben, da die Standorte der Messeinrichtungen und des betätigten Hochspannungsschalters ja bekannt sind.

**Fig. 2** zeigt ein zweites Ausführungsbeispiel für eine erfindungsgemäße Vorrichtung mit einer Ankopplung eines dreiphasigen Referenzsignals an den virtuellen Sternpunkt der Energieübertragungsleitung.

Die alternative Einspeisung von Referenzsignalen mithilfe eines virtuellen Sternpunkts erlaubt eine erdungsfreie Einspeisung eines dreiphasigen Referenzsignals.

Hier ist es vorgesehen, dass für jede Phase der Dreiphasenleitung K1-K3, L1-L3 ein gesondertes Prüfsignal U21, U31, U41 durch jeweilige Generatoren TX2-TX4 erzeugt wird und als zugehöriges Messsignal U22 durch einen Empfänger RX2 empfangen wird.

Das Koppelmittel ist in diesem Beispiel Transformatoren T2-T5 mit Wicklungen N21, N22, N31, N32, N41, N42, N51 und N52, Kondensatoren C21-C23 und Induktivitäten L21-L23 gebildet.

Für eine Verarbeitungs-Vorrichtung 11 und eine Steuer-Vorrichtung 21 gelten die Ausführungen der Fig.1 hinsichtlich des Messsignals U12, wie auch für die Aspekte der Dreiphasenleitung K1-K3, L1-L3 und die Störstelle 100.

Für beide Einspeisungsvarianten gemäß der Fig. 1 und Fig. 2 gelten nun die im Weiteren erörterten zusätzlichen Aspekte.

Es ist günstig, wenn mehrere Referenzsignale mit unterschiedlichen Amplituden und Frequenzbereichen angewendet werden, um durch eine wiederholte, adaptive Messung die Zuverlässigkeit der Störungsdetektion weiter zu erhöhen. Dabei können Sweeps oder Kaskaden von vordefinierten Frequenzen für das Prüfsignal angewendet werden, sowohl in einem Einton-, als auch in einem Mehrtonverfahren.

Neben den Intermodulationsprodukten können auch Harmonische des jeweiligen Referenzsignals ausgewertet werden.

Da im Messsignal auch die Netzspannung in Frequenz und Phase erkennbar ist, können zur Bestimmung von Intermodulationsprodukten auch phasensensitive Verfahren zum Einsatz kommen, wie eine synchrone Demodulation.

Dies kann eine feinere Unterscheidung der Intermodulationsquellen ermöglichen. Ferner kann ein größerer Signal-zu-Rausch-Abstand erreicht werden.

Das Prüfsignal kann unterschiedliche Signalverläufe aufweisen, wie sinusförmig, kodiert oder moduliert.

Ferner kann das Prüfsignal auf unterschiedliche Arten moduliert werden und mit bekannten Verfahren der digitalen Signalverarbeitung eine entsprechende Erkennung durchgeführt werden.

Zur Bewertung der Nichtlinearität müssen nicht unbedingt allein die Intermodulationsprodukte zwischen der Frequenz des Referenzsignals und der Netzfrequenz herangezogen werden.

Bei Aussendung eines Prüfsignals mit zwei oder mehr Frequenzen (Mehrton-Signal), wie auch bei Empfang von zwei oder mehr Referenzsignalen bei verschiedenen Frequenzen unterschiedlicher Prüfvorrichtungen im selben Leitungsnetz Prüfsignale können auch deren Mischprodukte untereinander betrachtet werden.

Dabei können die Anteile der harmonischen Verzerrungen der Netzspannung zufolge des Defekts eliminiert werden.

Anhand der gemessenen Intermodulationsprodukte kann eine Klassifizierung des erkannten Leitungsfehlers erfolgen.

In einem weiteren, nicht dargestellten Ausführungsbeispiel kann das Koppelmittel für eine einphasige Energieversorgungsleitung durch eine entsprechende Koppelschaltung analog zur Fig. 1, jedoch nur mit einer einzigen Koppelkapazität zur Energieversorgungsleitung.

Die folgenden Figuren zeigen jeweils Beispiele für ein sinusförmiges Messsignal mit einer Leistung 1 über einen Frequenzbereich 2.

**Fig. 3** zeigt ein erstes Beispiel für ein sinusförmiges Messsignal bei einer Mittenfrequenz von 30,0 kHz, welches ungeradzahlige Intermodulationsprodukte aufweist, welche für eine Lichtbogen-Detektion herangezogen werden kann.

Es sind Mischprodukte erkennbar bei 30 kHz $\pm$ 100 Hz, bei 30 kHz $\pm$ 200 Hz und bei 30 kHz $\pm$ 300 Hz.

Jedoch sind keine Mischprodukte bei 30 kHz $\pm$ 50 Hz, bei 30 kHz $\pm$ 150 Hz und bei 30 kHz $\pm$ 250 Hz erkennbar.

Die Charakteristik einer Nichtlinearität eines Lichtbogens führt zu ungeradzahligen Mischprodukten im Messsignal.

Die Charakteristik einer Nichtlinearität, welche durch Systemkomponenten in Mittelspannungsnetzen, wie sie von Transformatoren oder Kondensatoren hervorgerufen werden kann, führt vorwiegend zu geradzahligen Mischprodukten im Messsignal.

Somit kann neben einem Amplitudenunterschied von Reflexionen eines Prüfsignals an Systemkomponenten auch die Art der Mischprodukte (geradzahlig/ ungeradzahlig) im Messsignal zu einer Unterscheidung von Störungsursachen herangezogen werden, welche zur Bestimmung eines Lichtbogens verwendet wird.

**Fig. 4** zeigt ein zweites Beispiel für ein sinusförmiges Prüfsignal mit einer Mittenfrequenz von 30,0 kHz, jedoch gemessen bei dessen ersten harmonischen Frequenz von 60,0 kHz, und welches bei 60,0 kHz ebenfalls Intermodulationsprodukte aufweist.

Es sind Mischprodukte erkennbar bei 60 kHz $\pm$ 50 Hz, bei 60 kHz $\pm$ 150 Hz und bei 60 kHz $\pm$ 250 Hz.

Jedoch sind keine Mischprodukte bei 60 kHz $\pm$ 100 Hz und bei 60 kHz $\pm$ 200 Hz erkennbar.

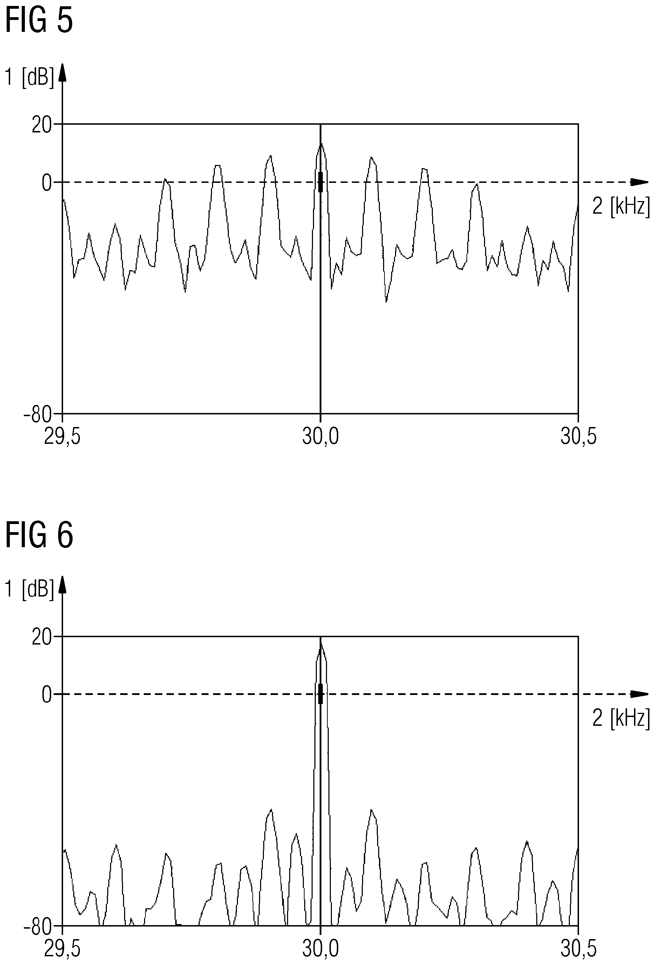

**Fig. 5** zeigt ein drittes Beispiel für ein schmalbandiges, sinusförmiges Messsignal bei einer Mittenfrequenz von 30,0 kHz, welches keine Intermodulationsprodukte aufweist. Folglich liegen keine ungeradzahligen Intermodulationsprodukte und daher kein Lichtbogen vor.

**Fig. 6** zeigt ein viertes Beispiel für ein schmalbandiges, sinusförmiges Messsignal bei einer Mittenfrequenz von 30,0 kHz, welches Intermodulationsprodukte aufweist.

Es sind ungeradzahlige Intermodulationsprodukte erkennbar bei 30 kHz $\pm$ 100 Hz, bei 30 kHz $\pm$ 200 Hz und bei 30 kHz $\pm$ 300 Hz.

Als Kriterium für eine Detektion eines Lichtbogens 100 kann somit zum einen der hohe Intermodulationspegel und zum anderen die Identifikation ungeradzahliger Intermodulationsprodukte sein.

**Bezugszeichenliste:**

| | |
|---|---|
| 1 | Leistung [dB] |
| 2 | Frequenz [kHz] |
| 10, 11 | Verarbeitungs-Vorrichtung |
| 20, 21 | Steuer-Vorrichtung |
| 100, 101 | Störstelle, Ort eines Lichtbogens |
| U11, U21, U31, U41 | Referenzsignal |
| U12, U22 | Messsignal |
| C11-C13, C21-C23 | Kapazität |
| K1-K3, HV | Mehrphasenleitung, Hochspannungsnetz |
| L1-L3, MV | Mehrphasenleitung, Mittelspannungsnetz |
| L11, L21-L23 | Induktivität |
| N11,N12,N13,N14, N21,N22,N31,N32, N41,N42,N51,N52 | Wicklung |
| RX1, RX2 | Messvorrichtung |

T0-T5                                   Transformator
TX1-TX4                                 Generator-Vorrichtung

**Patentansprüche**

1.  Verfahren zur Bestimmung eines Lichtbogens auf einer Energieübertragungsleitung (K1-K3, L1-L3), wobei zumindest ein Prüfsignal (U11, U21, U31, U41) in die Energieübertragungsleitung (K1-K3, L1-L3) eingekoppelt wird, und ein Störsignal an einer Störstelle (100), welche durch den Lichtbogen gebildet ist, längs der Energieübertragungsleitung (K1-K3, L1-L3) mithilfe des zumindest einen Prüfsignals (U11, U21, U31, U41) erzeugt wird, welches Störsignal als zumindest ein Messsignal (U12, U22) erfasst wird, und aus dem zumindest einen Messsignal (U12, U22) der Lichtbogen bestimmt wird, **dadurch gekennzeichnet, dass** der Lichtbogen durch Detektion zumindest eines Intermodulationsprodukts aus dem zumindest einen Prüfsignal (U11, U21, U31, U41) und dem Netzsignal der Energieübertragungsleitung (K1-K3, L1-L3) in dem zumindest einen Messsignal (U12, U22) bestimmt wird.

2.  Verfahren nach dem vorhergehenden Anspruch, wobei der Lichtbogen durch einen Schaltvorgang eines mit der Energieübertragungsleitung verbundenen Hochspannungsschalters hervorgerufen wird.

3.  Verfahren nach dem vorhergehenden Anspruch, wobei der Zeitpunkt des Schaltvorgang bei der Bestimmung des zumindest einen Leitungsparameters berücksichtigt wird.

4.  Verfahren nach einem der vorhergehenden Ansprüche, wobei der Lichtbogen durch eine Detektion ungeradzahliger Intermodulationsprodukte bestimmt wird.

5.  Verfahren nach einem der vorhergehenden Ansprüche, wobei der Lichtbogen durch zumindest ein Intermodulationsprodukt bis zur zehnten Ordnung bestimmt wird.

6.  Verfahren nach einem der vorhergehenden Ansprüche, wobei der Lichtbogen durch zumindest zwei Intermodulationsprodukte bestimmt wird.

7.  Verfahren nach dem vorhergehenden Anspruch, wobei der Lichtbogen durch das Verhältnis von Amplituden- und/oder Phasenbeträgen der zumindest zwei Intermodulationsprodukte bestimmt wird.

8.  Verfahren nach einem der vorhergehenden Ansprüche, wobei der Lichtbogen zusätzlich durch zumindest eine Harmonische des zumindest einen Prüfsignals (U11, U21, U31, U41) und/oder des zumindest einen Intermodulationsprodukts bestimmt wird.

9.  Verfahren nach einem der vorhergehenden Ansprüche, wobei das zumindest eine Prüfsignal (U11, U21, U31, U41) ein Verhältnis zwischen der Bandbreite und der Mittenfrequenz von weniger als 10%, bevorzugt weniger als 5%, besonders bevorzugt weniger als 3% oder weniger als 1,5% aufweist.

10. Verfahren nach einem der vorhergehenden Ansprüche, wobei das zumindest eine Prüfsignal (U11, U21, U31, U41) eine Frequenz aufweist, welche um einen Faktor 20 größer ist, als die Netzfrequenz der Energieübertragungsleitung (K1-K3, L1-L3), bevorzugt um einen Faktor 50 größer ist, besonders bevorzugt um einen Faktor 500 oder 1000 größer ist.

11. Verfahren nach einem der vorhergehenden Ansprüche, wobei zumindest eine Phasenbeziehung zwischen dem zumindest einen Prüfsignal (U11, U21, U31, U41) und dem zumindest einen Messsignal (U12, U22) bestimmt wird, welche zur Bestimmung des Orts des Auftretens der Störstelle (100, 101) der Energieübertragungsleitung (K1-K3, L1-L3) verwendet wird.

12. Vorrichtung zur Bestimmung eines Lichtbogens auf einer Energieübertragungsleitung (K1-K3, L1-L3), umfassend zumindest ein Koppelmittel zum Einkoppeln zumindest eines Prüfsignals (U11, U21, U31, U41) und zum Auskoppeln zumindest eines Messsignals (U12, U22) in und aus der Energieübertragungsleitung (K1-K3, L1-L3), und

   eine Verarbeitungs-Vorrichtung (10, 11) mit einer Steuer-Vorrichtung (20, 21), zumindest einer Generator-Vorrichtung (TX1, TX2, TX3, TX4) und zumindest einer Messvorrichtung (RX1, RX2),
   wobei die Steuer-Vorrichtung (20, 21) dazu eingerichtet ist, mithilfe der zumindest einen Generator-Vorrichtung (TX1, TX2, TX3, TX4) das zumindest eine Prüfsignal (U11, U21, U31, U41) zu erzeugen, und

mithilfe des zumindest einen Koppelmittels in die Energieübertragungsleitung (K1-K3, L1-L3) einzuspeisen, und zumindest ein Störsignal, welches an zumindest einer Störstelle (100), welche durch den Lichtbogen gebildet ist, längs der Energieübertragungsleitung (K1-K3, L1-L3) mithilfe des zumindest einen Prüfsignals (U11, U21, U31, U41) erzeugt wird, mithilfe des zumindest einen Koppelmittels (T1-T5, C11-C13, C21-C23, L11, L21-L23) von der Energieübertragungsleitung (K1-K3, L1-L3) auszukoppeln, und

mithilfe der zumindest einen Messvorrichtung (RX1, RX2) als das zumindest eine Messsignal (U12, U22) zu erfassen,

**dadurch gekennzeichnet, dass** die Verarbeitungs-Vorrichtung (10, 11) dazu eingerichtet ist, das Verfahren nach einem der vorhergehenden Ansprüche auszuführen und aus dem zumindest einen Messsignal (U12, U22) den Lichtbogen zu bestimmen.

13. Vorrichtung nach dem vorhergehenden Anspruch, wobei die Energieübertragungsleitung (K1-K3, L1-L3) eine Freileitung, ein Kabel, ein gasisolierter Rohrleiter oder eine Oberleitung für ein elektrisch betriebenes Verkehrsmittel ist

14. System zur Bestimmung eines Lichtbogens auf einer Energieübertragungsleitung (K1-K3, L1-L3) in Form einer Oberleitung, umfassend ein elektrisch betriebenes Verkehrsmittel mit einem Stromabnehmer zur Verbindung mit der Oberleitung und eine Vorrichtung nach Anspruch 12, wobei die Störstelle (100, 101) durch einen Lichtbogen zwischen der Oberleitung und dem Stromabnehmer gebildet ist.

**Claims**

1. Method for determining an arc on a power transmission line (K1-K3, L1-L3), wherein at least one test signal (U11, U21, U31, U41) is coupled into the power transmission line (K1-K3, L1-L3) and an interference signal at an interference point (100), which is formed by the arc, is generated along the power transmission line (K1-K3, L1-L3) with the aid of the at least one test signal (U11, U21, U31, U41), which interference signal is acquired as at least one measuring signal (U12, U22) and the arc is determined from the at least one measuring signal (U12, U22), **characterised in that** the arc is determined by detecting at least one intermodulation product from the at least one test signal (U11, U21, U31, U41) and the mains signal of the power transmission line (K1-K3, L1-L3) in the at least one measuring signal (U12, U22).

2. Method according to the preceding claim, wherein the arc is caused by a switching process of a high voltage switch connected to the power transmission line.

3. Method according to the preceding claim, wherein the time instant of the switching process is taken into account when the at least one line parameter is determined.

4. Method according to one of the preceding claims, wherein the arc is determined by detecting odd-numbered intermodulation products.

5. Method according to one of the preceding claims, wherein the arc is determined by at least one intermodulation product up to the tenth order.

6. Method according to one of the preceding claims, wherein the arc is determined by at least two intermodulation products.

7. Method according to the preceding claim, wherein the arc is determined by the ratio of amplitude and/or phase delays of the at least two intermodulation products.

8. Method according to one of the preceding claims, wherein the arc is additionally determined by at least one harmonic of the at least one test signal (U11, U21, U31, U41) and/or the at least one intermodulation product.

9. Method according to one of the preceding claims, wherein the at least one test signal (U11, U21, U31, U41) has a ratio between the bandwidth and the mean frequency of less than 10%, preferably less than 5%, particularly preferably less than 3% or less than 1.5%.

10. Method according to one of the preceding claims, wherein the at least one test signal (U11, U21, U31, U41) has a frequency which is greater by a factor 20 than the mains frequency of the power transmission line (K1-K3, L1-L3), preferably greater by a factor 50, particularly preferably greater by a factor 500 or 1000.

11. Method according to one of the preceding claims, wherein at least one phase relationship between the at least one test signal (U11, U21, U31, U41) and the at least one measuring signal (U12, U22) is determined and is used to determine the location of the occurrence of the interference point (100, 101) of the power transmission line (K1-K3, L1-L3).

12. Device for determining an arc on a power transmission line (K1-K3, L1-L3), comprising

at least one coupling means for coupling at least one test signal (U11, U21, U31, U41) into and for coupling at least one measuring signal (U12, U22) out of the power transmission line (K1-K3, L1-L3), and
a processing device (10, 11) with a control device (20, 21), at least one generator device (TX1, TX2, TX3, TX4) and at least one measuring device (RX1, RX2),
wherein the control device (20, 21) is designed to generate the at least one test signal (U11, U21, U31, U41) with the aid of the at least one generator device (TX1, TX2, TX3, TX4), and to feed the same into the power transmission line (K1-K3, L1-L3) with the aid of the at least one coupling means, and
to couple at least one interference signal, which is generated at at least one interference point (100) formed by the arc, along the power transmission line (K1-K3, L1-L3) with the aid of the at least one test signal (U11, U21, U31, U41), with the aid of the at least one coupling means (T1-T5, C11-C13, C21-C23, L11, L:21-23), out of the power transmission line (K1-K3, L1-L3), and
to detect the at least one measuring signal (U12, U22) with the aid of the at least one measuring device (RX1, RX2), **characterised in that**
the processing device (10, 11) is designed to execute the method according to one of the preceding claims and to determine the arc from the at least one measuring signal (U12, U22).

13. Device according to the preceding claim, wherein the power transmission line (K1-K3, L1, L3) is an overhead line, a cable, a gas-insulated tubular line or an overhead contact wire for an electrically operated means of transport.

14. System for determining an arc on a power transmission line (K1-K3, L1-L3) in the form of an overhead contact wire, comprising an electrically operated means of transport with a current collector for connection to the overhead contact wire and a device according to claim 12, wherein the interference point (100, 101) is formed by an arc between the overhead contact wire and the current collector.

**Revendications**

1. Procédé de détermination d'un arc électrique sur une ligne de transmission d'énergie (K1-K3, L1-L3), dans lequel au moins un signal d'essai (U11, U21, U31, U41) est injecté dans la ligne de transmission d'énergie (K1-K3, L1-L3), et un signal parasite est généré au niveau d'un point de perturbation (100), qui est formé par l'arc électrique, le long de la ligne de transmission d'énergie (K1-K3, L1-L3) à l'aide de l'au moins un signal d'essai (U11, U21, U31, U41), lequel signal parasite est détecté à titre de signal de mesure (U12, U22), et l'arc électrique est déterminé à partir de l'au moins un signal de mesure (U12, U22), **caractérisé en ce que** l'arc électrique est déterminé dans l'au moins un signal de mesure (U12, U22) par une détection d'au moins un produit d'intermodulation de l'au moins un signal d'essai (U11, U21, U31, U41) et du signal réseau de la ligne de transmission d'énergie (K1-K3, L1-L3).

2. Procédé selon la revendication précédente, dans lequel l'arc électrique est provoqué par un processus de commutation d'un commutateur à haute tension relié à la ligne de transmission d'énergie.

3. Procédé selon la revendication précédente, dans lequel le moment du processus de commutation est pris en compte dans la détermination de l'au moins un paramètre de ligne.

4. Procédé selon l'une des revendications précédentes, dans lequel l'arc électrique est déterminé par une détection de produits d'intermodulation impairs.

5. Procédé selon l'une des revendications précédentes, dans lequel l'arc électrique est déterminé par au moins un produit d'intermodulation jusqu'au dixième ordre.

**6.** Procédé selon l'une des revendications précédentes, dans lequel l'arc électrique est déterminé par au moins deux produits d'intermodulation.

**7.** Procédé selon l'une des revendications précédentes, dans lequel l'arc électrique est déterminé par le rapport des amplitudes et/ou des contributions de phase des au moins deux produits d'intermodulation.

**8.** Procédé selon l'une des revendications précédentes, dans lequel l'arc électrique est déterminé en outre par au moins un harmonique de l'au moins un signal d'essai (U11, U21, U31, U41) et/ou de l'au moins un produit d'intermodulation.

**9.** Procédé selon l'une des revendications précédentes, dans lequel l'au moins un signal d'essai (U11, U21, U31, U41) présente un rapport entre la largeur de bande passante et la fréquence centrale inférieur à 10 %, de préférence inférieur à 5 %, et de manière préférée inférieur à 3 % ou inférieur à 1,5 %.

**10.** Procédé selon l'une des revendications précédentes, dans lequel l'au moins un signal d'essai (U11, U21, U31, U41) a une fréquence qui est supérieure d'un facteur 20 à la fréquence réseau de la ligne de transmission d'énergie (K1-K3, L1-L3), de préférence supérieure d'un facteur 50, et de manière préférée supérieure d'un facteur 500 ou 1000.

**11.** Procédé selon l'une des revendications précédentes, dans lequel au moins une relation de phase entre l'au moins un signal d'essai (U11, U21, U31, U41) et l'au moins un signal de mesure (U12, U22) est déterminée, laquelle est utilisée pour déterminer le site de survenue du point de perturbation (100, 101) de la ligne de transmission d'énergie (K1-K3, L1-L3).

**12.** Dispositif pour déterminer un arc électrique sur une ligne de transmission d'énergie (K1-K3, L1-L3), comprenant :

au moins un moyen de couplage pour injecter au moins un signal d'essai (U11, U21, U31, U41) et pour extraire au moins un signal de mesure (U12, U22) dans et à partir de la ligne de transmission d'énergie (K1-K3, L1-L3), et un dispositif de traitement (10, 11) comprenant un dispositif de commande (20, 21), au moins un appareil de générateur (TX1, TX2, TX3, TX4) et au moins un dispositif de mesure (RX1, RX2), dans lequel le dispositif de commande (20, 21) est configuré pour générer l'au moins un signal d'essai (U11, U21, U31, U41) au moyen de l'au moins un appareil de générateur (TX1, TX2, TX3, TX4) et pour introduire l'au moins un moyen de couplage dans la ligne de transmission d'énergie (K1-K3, L1-L3), et pour extraire de la ligne de transmission d'énergie (K1-K3, L1-L3), en utilisant l'au moins un moyen de couplage (T1-T5, C11-C13, C21-C23, L11, L21-L23), au moins un signal parasite, qui est généré à l'aide de l'au moins un signal d'essai (U11, U21, U31, U41) au niveau d'au moins un point de perturbation (100) formé par l'arc électrique, le long de la ligne de transmission d'énergie (K1-K3, L1-L3), et pour détecter ledit signal parasite à titre de l'au moins un signal de mesure (U12, U22) au moyen de l'au moins un dispositif de mesure (RX1, RX2), **caractérisé en ce que** le dispositif de traitement (10, 11) est configuré pour exécuter le procédé selon l'une des revendications précédentes et pour déterminer l'arc électrique à partir de l'au moins un signal de mesure (U12, U22).

**13.** Dispositif selon la revendication précédente, dans lequel la ligne de transmission d'énergie (K1-K3, L1-L3) est une ligne aérienne, un câble, un conducteur tubulaire à isolation gazeuse ou une ligne de contact pour un moyen de transport à entraînement électrique.

**14.** Système permettant de déterminer un arc électrique sur une ligne de transmission d'énergie (K1-K3, L1-L3) sous forme d'une ligne de contact, comprenant un moyen de transport à entraînement électrique comprenant un pantographe à relier à la ligne de contact et un dispositif selon la revendication 12, dans lequel le point de perturbation (100, 101) est formé par un arc électrique entre la ligne de contact et le pantographe.

# FIG 1

# FIG 2

FIG 3

FIG 4

**FIG 5**

**FIG 6**

**EP 3 745 146 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 2018115144 A1
- US 2013226479 A1
- CN 108008244 A

### In der Beschreibung aufgeführte Nicht-Patentliteratur

- **KEENAN J et al.** ARC DETECTORS. *20TH INTERNATIONAL TELECOMMUNICATIONS ENERGY CONFERENCE, INTELEC '98,* 04. November 1998
- INTELEC. INTERNATIONAL TELECOMMUNICATIONS ENERGY CONFERENCE. IEEE, 04. Oktober 1998, 710-715